# EUROPÄISCHE PATENTANMELDUNG

(11) **EP 4 184 593 A1**
(43) Veröffentlichungstag der Anmeldung: **24.05.2023**
(21) Anmeldenummer: 21209614.3
(22) Anmeldetag: 22.11.2021
(51) Int. Cl.: H01L 31/048, H01L 31/055, H01L 31/054

(54) **ABDECKEINHEIT FÜR EIN SOLARMODUL, SOLARMODUL MIT DER ABDECKEINHEIT UND HERSTELLUNGSVERFAHREN FÜR ABDECKEINHEIT UND SOLARMODUL**

(71) Anmelder: CT-Coating AG, 53639 Königswinter (DE)
(72) Erfinder:
(74) Vertreter: Bernsmann, Falk

(57) **Zusammenfassung**

Die Erfindung betrifft ein Herstellungsverfahren zur Herstellung einer Abdeckeinheit (300) für ein Solarmodul (200), umfassend folgende Schritte: Bereitstellen eines flächigen und zumindest für sichtbares Licht durchlässigen Deckelements (320) und Bereitstellen einer Druckpaste, wobei die Druckpaste ein Bindemittel und eine Vielzahl von in dem Bindemittel verteilten Interferenzpartikeln (332) umfasst, und wobei die Interferenzpartikel (332) zur selektiven Reflektion eines Teilspektrums des sichtbaren Lichts durch Interferenz ausgestaltet sind. Das Herstellungsverfahren umfasst ein Siebdrucken der Druckpaste zumindest auf eine flächige Rückseite (321) des Deckelements (320) zur Erzeugung einer Reflektionsschicht (330) zur selektiven Reflektion des Teilspektrums. Die Erfindung betrifft ferner eine mit dem Herstellungsverfahren erhältliche Abdeckeinheit (300), ein Produktionsverfahren für ein Solarmodul (200) mit der Abdeckeinheit (300) und ein mit dem Produktionsverfahren erhältliches Solarmodul (200).

## Beschreibung

### Technisches Gebiet

Die Erfindung betrifft ein Herstellungsverfahren zur Herstellung einer Abdeckeinheit für ein Solarmodul, eine mit dem Herstellungsverfahren erhältliche Abdeckeinheit, ein Produktionsverfahren für ein Solarmodul, umfassend das Herstellungsverfahren, und ein mit dem Produktionsverfahren erhältliches Solarmodul.

### Stand der Technik

Nachteilig an bekannten Solarmodulen ist, dass ihr Aussehen nur sehr eingeschränkt angepasst werden kann, um die Solarmodule architektonisch in ein Bauwerk, beispielsweise in eine Fassade oder ein Dach, zu integrieren.

Es ist bisher nur möglich, die Solarmodule hinter einer farbigen oder streuenden Deckscheibe zu verbergen. Eine streuende Deckscheibe bewirkt nur eine geringe Gestaltungsfreiheit. Wenn die Glasscheibe mit absorbierenden Farbpigmente gefärbt ist, ergibt sich eine einfache und vielseitige Farbauswahl, aber die Effizienz des Solarmoduls wird erheblich verringert.

Durch den Einsatz einer selektiv reflektierenden Deckscheibe wird der Gesamtwirkungsgrad der Solarmodule nur minimal beeinflusst. Nachteilig ist aber die Winkelabhängigkeit des Farbeindruckes. Eine Verglasungseinheit mit einer Beschichtung, welche das Problem der Winkelabhängigkeit mindert, ist aus der Druckschrift US 2015/0249424 A1 bekannt. Diese Beschichtung besteht jedoch aus einem komplexen Schichtaufbau, der die Zahl der möglichen Farben und die Farbsättigung einschränkt.

Die Druckschrift WO 2018/154045 A1 offenbart eine selektiv reflektierende Verglasungseinheit mit einer photonischen Struktur für ein Solarmodul und ein Herstellungsverfahren dafür. Die Verglasungseinheit kann eine hohe Farbsättigung und eine Vielzahl von möglichen Farben und Gestaltungsmöglichkeiten mit geringer Winkelabhängigkeit des Farbeindruckes bieten, wobei Reflexionsverluste der Verglasungseinheit weniger als 9 % betragen können. Die photonische Struktur wird durch Sputtern auf eine strukturierte Oberfläche aufgebracht, wodurch das Herstellungsverfahren für übliche Größen von Solarmodulen langsam, energie- und kostenintensiv ist. Außerdem können Muster nur durch aufwändige Teilmaskierungen der Verglasungseinheit erzeugt werden.

### Technische Aufgabe

Die Aufgabe der Erfindung ist es, ein kostengünstiges, vielseitig gestaltbares und effizientes Solarmodul und ein Produktionsverfahren dafür zu schaffen.

### Technische Lösung

Die vorliegende Erfindung stellt ein Herstellungsverfahren gemäß Anspruch 1 bereit, das die technische Aufgabe löst. Ebenso wird die Aufgabe durch eine Abdeckeinheit gemäß Anspruch 7, ein Produktionsverfahren gemäß Anspruch 8 und ein Solarmodul gemäß Anspruch 15 gelöst. Vorteilhafte Ausgestaltungen sind Gegenstand der abhängigen Ansprüche.

Ein erfindungsgemäßes Herstellungsverfahren dient zur Herstellung einer Abdeckeinheit für ein Solarmodul. Das Solarmodul kann ein thermisches Solarmodul zur Gewinnung von thermischer Energie aus Sonnenlicht und/oder ein Photovoltaikmodul zur Gewinnung von elektrischer Energie aus Sonnenlicht umfassen. Die Abdeckeinheit kann eine dem Sonnenlicht zugewandte Seite des Solarmoduls zumindest teilweise abdecken, um das Aussehen das Solarmoduls zu verändern. Darüber hinaus kann die Abdeckeinheit dazu ausgelegt sein, das Solarmodul vor äußeren Einflüssen, beispielsweise vor Wasser und/oder Staub, zu schützen.

Das Herstellungsverfahren umfasst den Schritt: Bereitstellen eines flächigen und zumindest für sichtbares Licht durchlässigen Deckelements. Als sichtbares Licht wird Licht mit einer Wellenlänge von 400 nm bis 800 nm bezeichnet. Durchlässig bedeutet im Sinne dieser Beschreibung zumindest transluzent, bevorzugt transparent. Das Deckelement ist vorzugsweise für das gesamte sichtbare Wellenlängenspektrum durchlässig, wobei die Durchlässigkeit besonders bevorzugt von der Wellenlänge unabhängig ist, sodass das Deckelement farblos ist.

Das Deckelement besteht beispielsweise aus Glas oder aus einem Polymer, insbesondere aus Polymethylmethacrylat (PMMA) oder Polycarbonat (PC).

Das Deckelement ist flächig, das heißt das Deckelement in einer Deckelementebene eine Länge und eine zu der Länge orthogonale Breite, die beide wesentlich größer sind als, beispielsweise zumindest zehnmal so groß sind wie, insbesondere zumindest hundertmal so groß sind wie, eine zu der Deckelementebene orthogonale Höhe des Deckelements.

Die Form und Größe des Deckelements in der Deckelementebene ist vorzugsweise an das Solarmodul angepasst. Die Form des Deckelements in der Deckelementebene ist beispielsweise rechteckig. Die Höhe des Deckelements ist vorzugsweise so gewählt, dass das Deckelement für seine weitere Verarbeitung in dem Herstellungsverfahren und vorzugsweise zum Schutz des Solarmoduls eine ausreichende mechanische Stabilität hat.

Das Herstellungsverfahren umfasst den Schritt: Bereitstellen einer Druckpaste, wobei die Druckpaste ein Bindemittel und eine Vielzahl von in dem Bindemittel verteilten Interferenzpartikeln umfasst, und wobei die Interferenzpartikel zur selektiven Reflektion eines Teilspektrums des sichtbaren Lichts durch Interferenz ausgestaltet sind. Die Interferenzpartikel reflektieren also jeweils eine bestimmte Farbe oder einen bestimmten Farbbereich des auf sie auftreffenden Lichts, sodass eine Reflektionsschicht aus der Druckpaste einem Betrachter in dieser Farbe oder diesem Farbbereich erscheint.

Damit eine Reflektionsschicht aus der Druckpaste eine möglichst engen Wellenlängenbereich reflektiert, sind die Interferenzpartikel optisch möglichst gleichartig und haben insbesondere möglichst die gleiche Materialzusammensetzung, die gleiche Größe und/oder die gleiche Form.

Da die Farbe nicht durch absorbierende Farbstoffe erzeugt wird, kann sowohl eine hohe Farbsättigung als auch eine hohe Lichtdurchlässigkeit der Reflektionsschicht von beispielsweise zumindest 95 %, insbesondere zumindest 98 %, erreicht werden.

Die Verwendung von in einem Bindemittel verteilten Interferenzpartikeln zur selektiven Reflektion hat im Verhältnis zu den aus US 2015/0249424 A1 und WO 2018/154045 A1 bekannten Interferenzschichten den Vorteil, dass die Stärke der Reflektion nicht winkelabhängig ist, sodass die Farbe einer Reflektionsschicht aus der Druckpaste unabhängig von einem Betrachtungswinkel ist.

Das Verfahren umfasst den Schritt: Siebdrucken der Druckpaste zumindest auf eine flächige Rückseite des Deckelements zur Erzeugung einer Reflektionsschicht zur selektiven Reflektion des Teilspektrums. Zusätzlich kann die Druckpaste oder eine andere Druckpaste auch mit Siebdruck auf eine der Rückseite gegenüberliegende flächige Vorderseite des Deckelements gedruckt werden.

Durch Siebdrucken lässt sich die Reflektionsschicht, insbesondere auf ein großflächiges Deckelement, wesentlich schneller, kosteneffizienter und energieeffizienter aufbringen als die in US 2015/0249424 A1 und WO 2018/154045 A1 beschriebenen Interferenzschichten mit den dort genannten Verfahren. Außerdem können durch Siebdrucken auch mit geringem Aufwand Muster, beispielsweise Schriftzeichen, Wörter, Logos oder Bilder, aus der Druckpaste auf dem Deckelement erzeugt werden.

Durch Siebdrucken lässt sich kein Schichtsystem aus mehreren Schichten herstellen, deren Dicke so gleichmäßig und so gering ist, dass sichtbares Licht an dem Schichtsystem interferiert. Erfindungsgemäß wird dieses Problem dadurch gelöst, dass die Interferenz nicht durch ein System aus mehreren Schichten erzeugt wird wie in US 2015/0249424 A1 und WO 2018/154045 A1, sondern durch eine Vielzahl von optisch möglichst gleichartigen Interferenzpartikeln.

In dem erfindungsgemäßen Verfahren ist es sogar von Vorteil, dass eine durch Siebdruck erzeugte Schicht eine raue und somit matte Oberfläche hat, weil dadurch spiegelnde Reflektionen, die die Effizienz des Solarmoduls mindern und Personen in der Umgebung des Solarmoduls blenden könnten, vermieden werden.

### Beschreibung der Ausführungsarten

Das Bindemittel umfasst vorzugsweise einen keramischen Rohstoff, beispielsweise einen Silikat-Rohstoff, insbesondere ein Tonmineral oder ein Kaolin, oder einen oxidischen Rohstoff, insbesondere Aluminiumoxid oder Berylliumoxid.

Das Herstellungsverfahren umfasst vorzugsweise ein Brennen des Bindemittels zu einer keramischen Matrix nach dem Siebdrucken der Reflektionsschicht, wobei die Interferenzpartikel nach dem Brennen in der keramischen Matrix eingebettet sind. Das Brennen erfolgt beispielsweise bei einer Temperatur von 400 °C bis 900 °C, insbesondere bei 450 °C bis 800 °C.

Durch das Brennen zu einer keramischen Matrix wird eine mechanisch stabile Reflektionsschicht und Verbindung zum Deckelement erreicht. Außerdem entstehen eine hohe Transparenz, eine lange Lebensdauer und eine hohe Farbbeständigkeit der Reflektionsschicht.

Das Bindemittel umfasst vorzugsweise ein Polyaminoamid und/oder ein Polyamidharz, bevorzugt mit einer Massenkonzentration von 1 % bis 75 %, besonders bevorzugt von 5 % bis 55 %. Dadurch wird eine Druckpaste mit einer zum Siebdrucken vorteilhaften Viskosität erreicht, die gut an dem Deckelement haftet und sich beim Siebdrucken gleichmäßig auf dem Deckelement verteilen lässt.

Die Interferenzpartikel haben vorzugsweise einen Durchmesser von 50 nm bis 1000 nm, bevorzugt von 100 nm bis 800 nm.

Die Interferenzpartikel bestehen vorzugsweise aus einem Glas, das bevorzugt Siliziumoxid (SiO₂), Boroxid (B₂O₃), Natriumoxid (Na₂O), Kaliumoxid (K₂O) und/oder Aluminiumoxid (Al₂O₃) umfasst.

Die Interferenzpartikel sind vorzugsweise in der Druckpaste mit einer Massenkonzentration von 30 % bis 70 %, bevorzugt 45 % bis 55 %, besonders bevorzugt 50 %, enthalten.

Durch die genannten Eigenschaften der Interferenzpartikel ergeben sich eine hohe Lichtdurchlässigkeit, eine hohe Farbhomogenität und eine hohe Farbsättigung der Reflektionsschicht, wobei eine große Anzahl unterschiedlicher Farben erzeugt werden kann.

Das Herstellungsverfahren umfasst vorzugsweise den Schritt: Aufrauen zumindest einer Teilfläche der Rückseite und/oder einer der Rückseite gegenüberliegenden Vorderseite des Deckelements. Das Aufrauen kann die Haftung der Reflektionsschicht an dem Deckelement verbessern. Außerdem kann das Aufrauen spiegelnde Reflektionen an dem Deckelement, die die Effizienz des Solarmoduls mindern oder Passanten blenden könnten, verhindern.

Das Aufrauen findet vorzugsweise vor dem Siebdrucken der Reflektionsschicht auf die Rückseite statt. Das Aufrauen umfasst vorzugsweise ein Sandstrahlen, ein Ätzen, ein Prägen und/oder ein Walzen der Rückseite und/oder der Vorderseite. Das Aufrauen führt vorzugsweise zu einer RMS-Rauheit der Rückseite und/oder der Vorderseite von 30 nm bis 100 µm, bevorzugt von 80 nm bis 10 µm.

Das Herstellungsverfahren umfasst vorzugsweise ein Siebdrucken von mehreren Druckpasten zumindest auf die Rückseite des Deckelements zur Erzeugung mehrerer Reflektionsschichten zur selektiven Reflektion voneinander unterschiedlicher Teilspektren des sichtbaren Lichts umfasst, wobei die Druckpasten Interferenzpartikel zur selektiven Reflektion voneinander unterschiedlicher Teilspektren des sichtbaren Lichts durch Interferenz enthalten. Auf diese Weise können Muster aus mehreren Farben und/oder Farbflächen auf dem Deckelement erzeugt werden.

Eine erfindungsgemäße Abdeckeinheit für ein Solarmodul umfasst ein flächiges und für sichtbares Licht durchlässiges Deckelement und eine zumindest auf einer flächigen Rückseite des Deckelements aufgebrachte Reflektionsschicht zur selektiven Reflektion eines Teilspektrums des sichtbaren Lichts. Die Reflektionsschicht umfasst eine für sichtbares Licht durchlässige Matrix und eine Vielzahl von in der Matrix verteilten Interferenzpartikeln, wobei die Interferenzpartikel zur selektiven Reflektion des Teilspektrums durch Interferenz ausgestaltet sind. Die Abdeckeinheit ist durch ein erfindungsgemäßes Herstellungsverfahren herstellbar.

Die Abdeckeinheit kann wie zuvor zum erfindungsgemäßen Herstellungsverfahren beschrieben ausgestaltet sein, woraus sich die dort genannten Vorteile ergeben.

Ein erfindungsgemäßes Produktionsverfahren dient zur Produktion eines Solarmoduls und umfasst folgende Schritte:
a. Herstellen einer Abdeckeinheit mit einem erfindungsgemäßen Herstellungsverfahren,
b. Bereitstellen eines flächigen Trägerelements,
c. Siebdrucken einer Photovoltaikschicht zur Gewinnung elektrischer Energie aus sichtbarem Licht auf eine flächige Vorderseite des Trägerelements, und
d. Befestigen der Abdeckeinheit auf dem Trägerelement mit einem Befestigungsmittel, wobei die Rückseite des Deckelements der Abdeckeinheit parallel zur Vorderseite des Trägerelements ausgerichtet ist.

Ein weiteres erfindungsgemäßes Produktionsverfahren dient zur Produktion eines Solarmoduls und umfasst folgende Schritte:
a. Herstellen einer Abdeckeinheit mit einem erfindungsgemäßen Herstellungsverfahren,
b. Siebdrucken einer Photovoltaikschicht zur Gewinnung elektrischer Energie aus sichtbarem Licht auf die Rückseite des Deckelements der Abdeckeinheit,
c. Bereitstellen eines flächigen Trägerelements, und
d. Befestigen der Abdeckeinheit auf dem Trägerelement mit einem Befestigungsmittel, wobei die Rückseite des Deckelements parallel zu einer flächigen Vorderseite des Trägerelements ausgerichtet ist.

Das Trägerelement umfasst beispielsweise eine Schichtpressstoffplatte (HPL-Platte, HPL = High Pressure Laminate), eine Metallplatte, insbesondere eine Aluminiumplatte, eine Glasplatte oder eine Wärmedämmplatte.

Das Befestigungsmittel umfasst beispielsweise eine Anzahl von Klammern, eine Klebstoffschicht und/oder eine das Trägerelement und die Abdeckeinheit umschließende Hülle, wobei die Hülle beispielsweise durch eine Laminierung verschlossen ist.

Die Rückseite des Deckelements ist vorzugsweise der Vorderseite des Trägerelements zugewandt, sodass die Reflektionsschicht und die Photovoltaikschicht zwischen dem Deckelement und dem Trägerelement angeordnet und dadurch vor Umwelteinflüssen geschützt sind.

Die Photovoltaikschicht ist vorzugsweise als low-light-condition-Solarmodul und/oder als Dünnschichtsolarmodul ausgestaltet, umfassend beispielsweise amorphes Silicium (a-Si:H), mikrokristallines Silicium (µc-Si:H), GalliumArsenid (GaAs), Cadmiumtellurid (CdTe) oder Kupfer-Indium-(Gallium)-Schwefel-Selen-Verbindungen als photoaktives Material.

Die Photovoltaikschicht umfasst vorzugsweise einen Fluoreszenzfarbstoff zur Umwandlung von ultraviolettem Licht in sichtbares Licht. Dadurch kann auch das ultraviolette Licht zur Gewinnung elektrischer Energie genutzt werden, wodurch die Leistung des Solarmoduls, insbesondere bei geringer Umgebungshelligkeit, steigt.

Eine Druckpaste, aus der die Photovoltaikschicht siebgedruckt wird, umfasst vorzugsweise eine Photoinitiator zur Initiierung einer Polymerisation der Photovoltaikschicht. Das Produktionsverfahren umfasst vorzugsweise ein Initiieren der Polymerisation der Photovoltaikschicht durch eine Belichtung der Photovoltaikschicht, insbesondere mit ultraviolettem Licht. Der Photoinitiator kann beispielsweise kationisch, radikalisch, niedermolekular oder polymer sein.

Der Photoinitiator erlaubt eine Verfestigung der Photovoltaikschicht, ohne die Photovoltaikschicht zu erhitzen, wodurch die Photovoltaikschicht oder andere Schichten des Solarmoduls beschädigt werden könnten.

Das Bereitstellen des Trägerelements umfasst vorzugsweise ein Gießen des Trägerelements aus einem Wärmedämmstoff, wobei der Wärmedämmstoff bevorzugt eine Gussmasse mit einem Blähglas und einem Bindemittel umfasst. Durch den Wärmedämmstoff kann eine Fassade oder ein Dach eines Gebäudes mit dem Solarmodul thermisch gedämmt werden, ohne dass dafür in einem separaten Schritt ein Wärmedämmmaterial an dem Gebäude angebracht werden müsste.

Ein gegossener Wärmedämmstoff hat gegenüber anderen, beispielsweise fasrigen, Wärmedämmstoffen den Vorteil, dass weitere Schichten des Solarmoduls darauf direkt durch Siebrucken aufgebracht werden können. Blähglas hat als Wärmedämmstoff den Vorteil, dass es mit einem Binder eine zum Gießen des Trägerelements geeignete Gussmasse bilden kann. Außerdem bietet Blähglas neben einer hohen Wärmedämmung auch eine hohe Hitzebeständigkeit, wodurch die Lebensdauer des Solarmoduls erhöht wird.

Das Produktionsverfahren umfasst vorzugsweise den Schritt: Siebdrucken einer Energiespeicherschicht zur Speicherung der von der Photovoltaikschicht gewonnenen elektrischen Energie auf das Trägerelement vor dem Siebdrucken der Photovoltaikschicht auf das Trägerelement oder auf die Photovoltaikschicht nach dem Siebdrucken der Photovoltaikschicht auf das Deckelement. Die Energiespeicherschicht ist somit auf der von dem Deckelement abgewandten Seite der Photovoltaikschicht angeordnet und behindert somit die Lichteinstrahlung durch das Deckelement auf die Photovoltaikschicht nicht.

Die Energiespeicherschicht erlaubt eine gleichmäßige Leistungsabgabe des Solarmoduls auch dann, wenn die Leistungsabgabe der Photovoltaikschicht durch eine wechselnde Umgebungshelligkeit schwankt. Dadurch kann das Solarmodul einfacher in ein Energieversorgungssystem eines Gebäudes integriert werden.

Die Energiespeicherschicht ist vorzugsweise gegenüber einer Temperatur von zumindest 60 °C, insbesondere zumindest 85 °C, bevorzugt zumindest 120 °C, beständig. Durch diese gegenüber fachüblichen Energiespeichern, beispielsweise Lithium-Ionen-Akkumulatoren, erhöhte Wärmebeständigkeit kann die Energiespeicherschicht vorteilhafterweise in einem kompakten Modul mit der Heizschicht kombiniert werden, ohne dass die Energiespeicherschicht durch von der Heizschicht abgegebene Wärme beschädigt wird.

Die Energiespeicherschicht kann flüssigkeitsfrei ausgebildet sein, NatriumIonen und insbesondere keine Lithium-Ionen als bewegliche Ladungsträger enthalten und/oder frei von Fehlstellen (sogenannten "Pinholes") ausgebildet sein. Jedes dieser Merkmale und insbesondere eine Kombination mehrerer dieser Merkmale erhöht vorteilhafterweise die Wärmebeständigkeit der Energiespeicherschicht.

Die Energiespeicherschicht ist vorzugsweise als Festkörperakkumulator, beispielsweise als Lithium-Luft-Festkörperakkumulator, oder als Superkondensator ausgebildet.

Das Produktionsverfahren umfasst vorzugsweise den Schritt: Siebdrucken einer thermischen Isolierschicht zwischen der Energiespeicherschicht und der Photovoltaikschicht auf das Trägerelement oder auf das Deckelement. Die thermische Isolierschicht schützt die Energiespeicherschicht vor einer Überhitzung durch die Photovoltaikschicht und/oder durch auf die Photovoltaikschicht einfallendes Licht.

Die Isolierschicht umfasst vorzugsweise ein Calcium-Silikat, Chitosan und/oder einen hitzebeständigen Binder. Mit den genannten Inhaltsstoffen lässt sich auf einfache Weise, beispielsweise durch Siebdrucken, eine besonders dünne und flexible Isolierschicht mit einer geringen Wärmeleitfähigkeit herstellen. Die Isolierschicht weist vorzugsweise eine Schichtdicke senkrecht zur Deckelementebene von 10 µm bis 500 µm, bevorzugt von 40 µm bis 100 µm, auf.

Das Produktionsverfahren umfasst vorzugsweise den Schritt: Siebdrucken einer Leuchtschicht zur Beleuchtung einer Umgebung des Solarmoduls auf das Trägerelement oder auf das Deckelement. Die Leuchtschicht kann direkt auf des Trägerelement oder auf das Deckelement gedruckt werden oder auf eine der zuvor genannten Schichten, wobei zwischen die zuvor genannte Schicht und die Leuchtschicht vorzugsweise eine elektrische Isolierschicht durch Siebdruck aufgebracht wird.

Die Leuchtschicht wird vorzugsweise auf der dem Deckelement zugewandten Seite der Photovoltaikschicht angeordnet. Dadurch wird eine Abgabe von Licht von der Leuchtschicht durch das Deckelement nicht durch die Photovoltaikschicht behindert.

Die Leuchtschicht wird vorzugsweise auf einer der Reflektionsschicht abgewandten Vorderseite des Deckelements angeordnet. Dadurch wird eine Abgabe von Licht von der Leuchtschicht an die Umgebung nicht durch die Reflektionsschicht behindert.

Die Leuchtschicht kann beispielsweise eine Elektrolumineszenz-Schicht und/oder eine OLED-Schicht umfassen. Die Leuchtschicht ist vorzugsweise für sichtbares Licht durchlässig. Dadurch kann die Leuchtschicht auf der dem Deckelement zugewandten Seite der Photovoltaikschicht angebracht werden, ohne die Energiegewinnung durch die Photovoltaikschicht zu beeinträchtigen.

Eine Schichtdicke der Leuchtschicht, der Energiespeicherschicht und/oder der Photovoltaikschicht senkrecht zur Deckelementebene beträgt vorzugsweise jeweils von 0,1 µm bis 1 mm, bevorzugt von 0,5 µm bis 0,2 mm.

Das Produktionsverfahren umfasst vorzugsweise den Schritt: Siebdrucken einer Wärmeleitschicht zur Ableitung von Wärme von der Photovoltaikschicht auf das Trägerelement vor dem Siebdrucken der Photovoltaikschicht auf das Trägerelement oder auf die Photovoltaikschicht nach dem Siebdrucken der Photovoltaikschicht auf das Deckelement. Die Energiespeicherschicht ist somit auf der von dem Deckelement abgewandten Seite der Photovoltaikschicht angeordnet und behindert somit die Lichteinstrahlung durch das Deckelement auf die Photovoltaikschicht nicht.

Die Wärmeleitschicht, die beispielsweise eine Nanokeramik umfasst, verhindert eine Überhitzung der Photovoltaikschicht, die den Wirkungsgrad der Photovoltaikschicht verringern oder die Photovoltaikschicht beschädigen könnte.

Ein erfindungsgemäßes Solarmodul ist mit einem erfindungsgemäßen Produktionsverfahren erhältlich und umfasst ein flächiges Trägerelement und eine erfindungsgemäße Abdeckeinheit. Die Abdeckeinheit ist mit einem Befestigungsmittel auf dem Trägerelement befestigt, wobei die Rückseite des Deckelements der Abdeckeinheit parallel zu einer flächigen Vorderseite des Trägerelements ausgerichtet ist, und wobei zwischen dem Deckelement und dem Trägerelement eine Photovoltaikschicht zur Gewinnung elektrischer Energie aus sichtbarem Licht angeordnet ist.

Das Solarmodul kann wie zuvor zum Herstellungsverfahren und zum Produktionsverfahren beschrieben ausgestaltet sein, woraus sich die dort genannten Vorteile ergeben.

### Kurze Beschreibung der Zeichnungen

Weitere Vorteile, Ziele und Eigenschaften der Erfindung werden anhand nachfolgender Beschreibung und anliegender Zeichnungen erläutert, in welchen beispielhaft erfindungsgemäße Gegenstände dargestellt sind.
Figur 1 zeigt schematisch ein erfindungsgemäßes Produktionsverfahren.
Figur 2 zeigt schematisch ein weiteres erfindungsgemäßes Produktionsverfahren.
Figur 3 zeigt schematisch eine erfindungsgemäße Abdeckeinheit.
Figur 4 zeigt schematisch ein erfindungsgemäßes Solarmodul.

### Fig.1

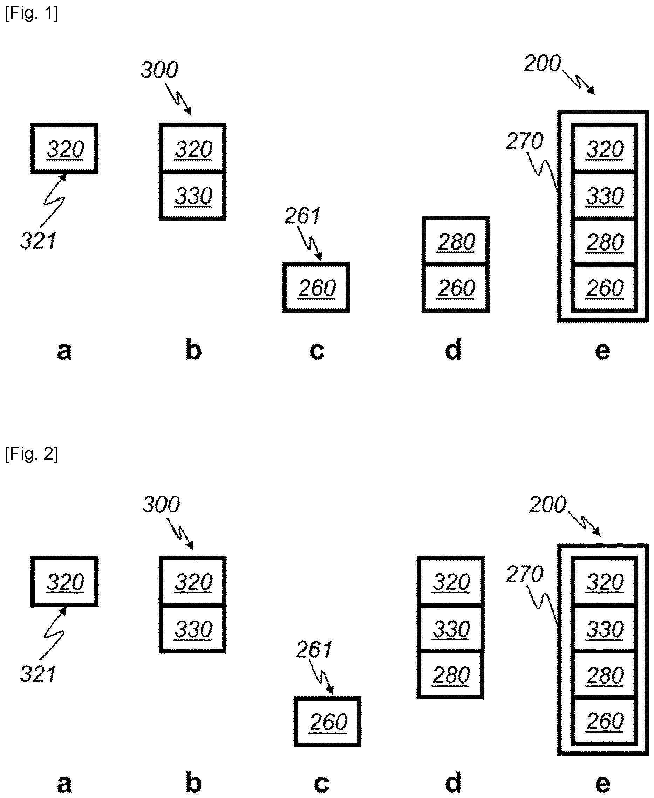

Figur 1 zeigt schematisch ein erfindungsgemäßes Produktionsverfahren für ein erfindungsgemäßes Solarmodul 200.

Das gezeigte Produktionsverfahren umfasst in Schritt a ein Bereitstellen eines flächigen und zumindest für sichtbares Licht durchlässigen Deckelements 320, beispielsweise einer Glasscheibe.

Das Produktionsverfahren umfasst in Schritt b ein Bereitstellen einer Druckpaste, wobei die Druckpaste ein Bindemittel und eine Vielzahl von in dem Bindemittel verteilten Interferenzpartikeln umfasst, und wobei die Interferenzpartikel zur selektiven Reflektion eines Teilspektrums des sichtbaren Lichts durch Interferenz ausgestaltet sind, und ein Siebdrucken der Druckpaste zumindest auf eine flächige Rückseite 321 des Deckelements 320 zur Erzeugung einer Reflektionsschicht 330 zur selektiven Reflektion des Teilspektrums.

Das Deckelement 320 und die Reflektionsschicht 330 bilden zusammen eine erfindungsgemäße Abdeckeinheit 300.

Das Produktionsverfahren umfasst in Schritt c ein Bereitstellen eines flächigen Trägerelements 260, beispielsweise einer Schichtpressstoffplatte.

Das Produktionsverfahren umfasst in Schritt d ein Siebdrucken einer Photovoltaikschicht 280 zur Gewinnung elektrischer Energie aus sichtbarem Licht auf eine flächige Vorderseite 261 des Trägerelements 260.

Das Produktionsverfahren umfasst in Schritt e ein Befestigen der Abdeckeinheit 300 auf dem Trägerelement 260 mit einem Befestigungsmittel 270, beispielsweise mit einer die Abdeckeinheit 300 und das Trägerelement 260 umschließenden Hülle. Die Rückseite 321 des Deckelements 320 der Abdeckeinheit 300 ist dabei parallel zur Vorderseite 261 des Trägerelements 260 ausgerichtet, insbesondere der Vorderseite 261 zugewandt.

### Fig.2

Figur 2 zeigt schematisch ein weiteres erfindungsgemäßes Produktionsverfahren für ein erfindungsgemäßes Solarmodul 200.

Die Schritte a, b, c und e des in Figur 2 gezeigten Produktionsverfahrens entsprechen den mit gleichen Buchstaben bezeichneten Schritten des in Figur 1 gezeigten Produktionsverfahrens.

Im Unterschied zu Figur 1 wird in Figur 2 in Schritt d die Photovoltaikschicht 280 nicht auf das Trägerelement 260, sondern auf die Reflektionsschicht 330 auf dem Deckelement 320 durch Siebdruck aufgebracht.

In Schritt e entsteht durch das Befestigen der Abdeckeinheit 300 auf dem Trägerelement 260 ein Solarmodul 200 mit der gleichen Schichtreihenfolge wie in Figur 1.

### Fig.3

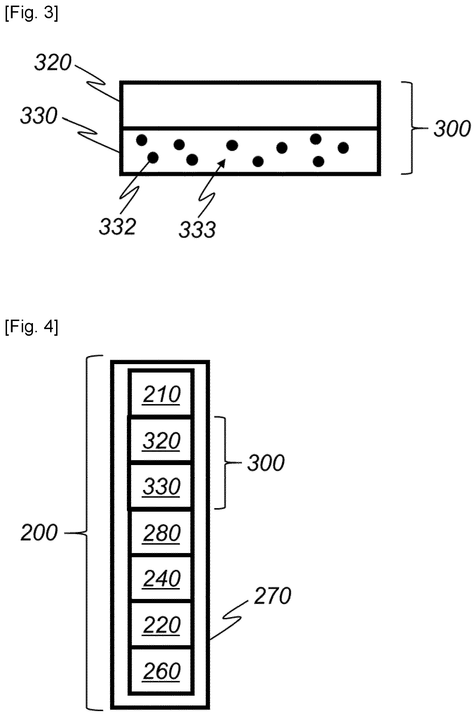

Figur 3 zeigt schematisch eine erfindungsgemäße Abdeckeinheit 300 für ein Solarmodul. Die Abdeckeinheit 300 umfasst ein flächiges und für sichtbares Licht durchlässiges Deckelement 320, beispielsweise eine Glasscheibe, und eine auf einer flächigen Rückseite (in Figur 3 unten) des Deckelements 320 aufgebrachte Reflektionsschicht 330 zur selektiven Reflektion eines Teilspektrums des sichtbaren Lichts.

Die Reflektionsschicht 330 umfasst eine für sichtbares Licht durchlässige Matrix 333, insbesondere eine keramische Matrix 333, und eine Vielzahl von in der Matrix 333 verteilten Interferenzpartikeln 332, wobei die Interferenzpartikel 332 zur selektiven Reflektion des Teilspektrums durch Interferenz ausgestaltet sind. Die Interferenzpartikel 332 bestehen beispielsweise aus einem Glas, haben einen Durchmesser von 100 nm bis 800 nm und haben einen Massenanteil von etwa 50 % an der Reflektionsschicht 330.

### Fig.4

Figur 4 zeigt schematisch ein erfindungsgemäßes Solarmodul 200. Das Solarmodul 200 umfasst ein flächiges Trägerelement 260, beispielsweise eine Schichtpressstoffplatte, und eine erfindungsgemäße Abdeckeinheit 300, die beispielsweise wie in Figur 3 gezeigt ausgestaltet sein kann.

Die Abdeckeinheit 300 ist mit einem Befestigungsmittel 270, beispielsweise mit einer die Abdeckeinheit 300 und das Trägerelement 260 umschließenden Hülle, auf dem Trägerelement 260 befestigt, wobei die Rückseite (in Figur 4 unten) des Deckelements 320 der Abdeckeinheit 300 parallel zu einer flächigen Vorderseite (in Figur 4 oben) des Trägerelements 260 ausgerichtet, bevorzugt der Vorderseite zugewandt, ist.

Zwischen dem Deckelement 320 und dem Trägerelement 260 ist eine Photovoltaikschicht 280 zur Gewinnung elektrischer Energie aus sichtbarem Licht angeordnet. Die Photovoltaikschicht 280 grenzt beispielsweise an die Reflektionsschicht 330 der Abdeckeinheit 300 an.

Das Solarmodul 200 kann eine Energiespeicherschicht 220 zur Speicherung der von der Photovoltaikschicht 280 gewonnenen elektrischen Energie umfassen. Die Energiespeicherschicht 220 ist vorzugsweise zwischen der Photovoltaikschicht 280 und dem Trägerelement 260 angeordnet, wobei besonders bevorzugt zwischen der Photovoltaikschicht 280 und der Energiespeicherschicht 220 eine thermische Isolierschicht 240 angeordnet ist.

Das Solarmodul 200 kann eine Leuchtschicht 210 zur Beleuchtung einer Umgebung des Solarmoduls 200 umfassen. Die Leuchtschicht 210 ist vorzugsweise auf einer der Reflektionsschicht 330 abgewandten Vorderseite (in Figur 4 oben) des Deckelements 320 angeordnet.

Vorzugsweise werden die Abdeckeinheit 300, das Trägerelement 260 und die vorgenannten Schichten 330, 280, 240, 220 von dem als Hülle ausgestalteten Befestigungsmittel 270 umschlossen.

Vorzugsweise entspricht die Schichtreihenfolge des Solarmoduls 200 der in Figur 4 gezeigten Schichtreihenfolge (von unten nach oben): Trägerelement 260, optionale Energiespeicherschicht 220, optionale thermische Isolierschicht 240, Photovoltaikschicht 280, Reflektionsschicht 330, Deckelement 320, optionale Leuchtschicht 210.

**Liste der Bezugszeichen**

| | | | |
|---|---|---|---|
| 200 | Solarmodul | 300 | Abdeckeinheit |
| 210 | Leuchtschicht | 320 | Deckelement |
| 220 | Energiespeicherschicht | 321 | Rückseite des Deckelements |
| 240 | Isolierschicht | 330 | Reflektionsschicht |
| 260 | Trägerelement | 332 | Interferenzpartikel |
| 261 | Vorderseite des Trägerelements | 333 | Matrix |
| 270 | Befestigungsmittel | | |
| 280 | Photovoltaikschicht | | |

## Patentansprüche

1. Herstellungsverfahren zur Herstellung einer Abdeckeinheit (300) für ein Solarmodul (200), umfassend folgende Schritte:
a. Bereitstellen eines flächigen und zumindest für sichtbares Licht durchlässigen Deckelements (320),
b. Bereitstellen einer Druckpaste,
i. wobei die Druckpaste ein Bindemittel und eine Vielzahl von in dem Bindemittel verteilten Interferenzpartikeln (332) umfasst, und
ii. wobei die Interferenzpartikel (332) zur selektiven Reflektion eines Teilspektrums des sichtbaren Lichts durch Interferenz ausgestaltet sind, und
c. Siebdrucken der Druckpaste zumindest auf eine flächige Rückseite (321) des Deckelements (320) zur Erzeugung einer Reflektionsschicht (330) zur selektiven Reflektion des Teilspektrums.

2. Herstellungsverfahren nach Anspruch 1,
**dadurch gekennzeichnet, dass**
a. das Bindemittel einen keramischen Rohstoff umfasst,
b. wobei das Herstellungsverfahren nach dem Siebdrucken der Reflektionsschicht (330) ein Brennen des Bindemittels zu einer keramischen Matrix (333) umfasst,
c. wobei die Interferenzpartikel (332) nach dem Brennen in der keramischen Matrix (333) eingebettet sind.

3. Herstellungsverfahren nach Anspruch 1 oder 2,
**dadurch gekennzeichnet, dass**
das Bindemittel ein Polyaminoamid und/oder ein Polyamidharz, bevorzugt mit einer Massenkonzentration von 1 % bis 75 %, besonders bevorzugt von 5 % bis 55 %, umfasst.

4. Herstellungsverfahren nach einem der Ansprüche 1 bis 3,
**dadurch gekennzeichnet, dass**
die Interferenzpartikel (332)
a. einen Durchmesser von 50 nm bis 1000 nm, bevorzugt von 100 nm bis 800 nm, haben;
b. aus einem Glas bestehen, das bevorzugt Siliziumoxid (SiO₂), Boroxid (B₂O₃), Natriumoxid (Na₂O), Kaliumoxid (K₂O) und/oder Aluminiumoxid (Al₂O₃) umfasst; und/oder
c. in der Druckpaste mit einer Massenkonzentration von 30 % bis 70 %, bevorzugt 45 % bis 55 %, besonders bevorzugt 50 %, enthalten sind.

5. Herstellungsverfahren nach einem der Ansprüche 1 bis 4,
**gekennzeichnet durch** den Schritt:
Aufrauen zumindest einer Teilfläche der Rückseite (321) und/oder einer der Rückseite (321) gegenüberliegenden Vorderseite des Deckelements (320), wobei das Aufrauen bevorzugt
a. vor dem Siebdrucken der Reflektionsschicht (330) auf die Rückseite (321) stattfindet,
b. ein Sandstrahlen, ein Ätzen, ein Prägen und/oder ein Walzen der Rückseite (321) und/oder der Vorderseite umfasst und/oder
c. zu einer RMS-Rauheit der Rückseite (321) und/oder der Vorderseite von 30 nm bis 100 µm, bevorzugt von 80 nm bis 10 µm, führt.

6. Herstellungsverfahren nach einem der Ansprüche 1 bis 5,
**dadurch gekennzeichnet, dass**
a. das Herstellungsverfahren ein Siebdrucken von mehreren Druckpasten zumindest auf die Rückseite (321) des Deckelements (320) zur Erzeugung mehrerer Reflektionsschichten (330) zur selektiven Reflektion voneinander unterschiedlicher Teilspektren des sichtbaren Lichts umfasst,
b. wobei die Druckpasten Interferenzpartikel (332) zur selektiven Reflektion voneinander unterschiedlicher Teilspektren des sichtbaren Lichts durch Interferenz enthalten.

7. Abdeckeinheit (300) für ein Solarmodul (200), umfassend
a. ein flächiges und für sichtbares Licht durchlässiges Deckelement (320) und
b. eine zumindest auf einer flächigen Rückseite (321) des Deckelements (320) aufgebrachte Reflektionsschicht (330) zur selektiven Reflektion eines Teilspektrums des sichtbaren Lichts,
c. wobei die Reflektionsschicht (330)
i. eine für sichtbares Licht durchlässige Matrix (333) und
ii. eine Vielzahl von in der Matrix (333) verteilten Interferenzpartikeln (332) umfasst, wobei die Interferenzpartikel (332) zur selektiven Reflektion des Teilspektrums durch Interferenz ausgestaltet sind,
d. wobei die Abdeckeinheit (300) durch ein Herstellungsverfahren nach einem der Ansprüche 1 bis 6 herstellbar ist.

8. Produktionsverfahren zur Produktion eines Solarmoduls (200), umfassend folgende Schritte:
a. Herstellen einer Abdeckeinheit (300) mit einem Herstellungsverfahren nach einem der Ansprüche 1 bis 6,
b. Bereitstellen eines flächigen Trägerelements (260),
c. Siebdrucken einer Photovoltaikschicht (280) zur Gewinnung elektrischer Energie aus sichtbarem Licht auf eine flächige Vorderseite (261) des Trägerelements (260),
i. wobei das Siebdrucken der Photovoltaikschicht (280) bevorzugt mit einer Druckpaste erfolgt, die einen Fluoreszenzfarbstoff zur Umwandlung von ultraviolettem Licht in sichtbares Licht und/oder einen Photoinitiator zur Initiierung einer Polymerisation der Photovoltaikschicht umfasst, und
d. Befestigen der Abdeckeinheit (300) auf dem Trägerelement (260) mit einem Befestigungsmittel (270), wobei die Rückseite (321) des Deckelements (320) der Abdeckeinheit (300) parallel zur Vorderseite (261) des Trägerelements (260) ausgerichtet ist.

9. Produktionsverfahren zur Produktion eines Solarmoduls (200), umfassend folgende Schritte:
a. Herstellen einer Abdeckeinheit (300) mit einem Herstellungsverfahren nach einem der Ansprüche 1 bis 6,
b. Siebdrucken einer Photovoltaikschicht (280) zur Gewinnung elektrischer Energie aus sichtbarem Licht auf die Rückseite (321) des Deckelements (320) der Abdeckeinheit (300),
i. wobei das Siebdrucken der Photovoltaikschicht (280) bevorzugt mit einer Druckpaste erfolgt, die einen Fluoreszenzfarbstoff zur Umwandlung von ultraviolettem Licht in sichtbares Licht und/oder einen Photoinitiator zur Initiierung einer Polymerisation der Photovoltaikschicht umfasst,
c. Bereitstellen eines flächigen Trägerelements (260), und
d. Befestigen der Abdeckeinheit (300) auf dem Trägerelement (260) mit einem Befestigungsmittel (270), wobei die Rückseite (321) des Deckelements (320) parallel zu einer flächigen Vorderseite (261) des Trägerelements (260) ausgerichtet ist.

10. Produktionsverfahren nach Anspruch 8 oder 9,
**dadurch gekennzeichnet, dass**,
das Bereitstellen des Trägerelements (260) ein Gießen des Trägerelements (260) aus einem Wärmedämmstoff umfasst, wobei der Wärmedämmstoff bevorzugt eine Gussmasse mit einem Blähglas und einem Bindemittel umfasst.

11. Produktionsverfahren nach einem der Ansprüche 8 bis 10,
**gekennzeichnet durch** den Schritt:
Siebdrucken einer Energiespeicherschicht (220) zur Speicherung der von der Photovoltaikschicht (280) gewonnenen elektrischen Energie
a. auf das Trägerelement (260) vor dem Siebdrucken der Photovoltaikschicht (280) auf das Trägerelement (260) oder
b. auf die Photovoltaikschicht (280) nach dem Siebdrucken der Photovoltaikschicht (280) auf das Deckelement (320).

12. Produktionsverfahren nach Anspruch 11,
**gekennzeichnet durch** den Schritt:
Siebdrucken einer thermischen Isolierschicht (240) zwischen der Energiespeicherschicht (220) und der Photovoltaikschicht (280) auf das Trägerelement (260) oder auf das Deckelement (320).

13. Produktionsverfahren nach einem der Ansprüche 8 bis 12,
**gekennzeichnet durch** den Schritt:
Siebdrucken einer Leuchtschicht (210) zur Beleuchtung einer Umgebung des Solarmoduls (200) auf das Trägerelement (260) oder auf das Deckelement (320).

14. Produktionsverfahren nach einem der Ansprüche 8 bis 13,
**gekennzeichnet durch** den Schritt:
Siebdrucken einer Wärmeleitschicht zur Ableitung von Wärme von der Photovoltaikschicht (280)
a. auf das Trägerelement (260) vor dem Siebdrucken der Photovoltaikschicht (280) auf das Trägerelement (260) oder
b. auf die Photovoltaikschicht (280) nach dem Siebdrucken der Photovoltaikschicht (280) auf das Deckelement (320).

15. Solarmodul (200), erhältlich mit einem Produktionsverfahren gemäß einem der Ansprüche 8 bis 14, das Solarmodul (200) umfassend:
a. ein flächiges Trägerelement (260) und
b. eine Abdeckeinheit (300) nach Anspruch 7,
c. wobei die Abdeckeinheit (300) mit einem Befestigungsmittel (270) auf dem Trägerelement (260) befestigt ist,
d. wobei die Rückseite (321) des Deckelements (320) der Abdeckeinheit (300) parallel zu einer flächigen Vorderseite (261) des Trägerelements (260) ausgerichtet ist, und
e. wobei zwischen dem Deckelement (320) und dem Trägerelement (260) eine Photovoltaikschicht (280) zur Gewinnung elektrischer Energie aus sichtbarem Licht angeordnet ist.
